# EUROPEAN PATENT APPLICATION

(11) **EP 2 093 184 A2**
(43) Date of publication of application: **26.08.2009**
(21) Application number: 09152338.1
(22) Date of filing: 07.02.2009
(51) Int. Cl.: B81B 7/00

(54) **MEMS device with temperature compensation**

(30) Priority: 21.02.2008 US 34905
(71) Applicant: Honeywell International Inc., Morristown, NJ 07962 (US)
(72) Inventor: Ridley, Jeff A., Morristown, NJ 07962 (US); Higashi, Robert, Morristown, NJ 07962 (US); Detry, James F., Morristown, NJ 07962 (US)
(74) Representative: Buckley, Guy Julian

(57) **Abstract**

A MEMS device includes a P-N device formed on a silicon pin, which is connected to a silicon sub-assembly, and where the P-N device is formed on a silicon substrate that is used to make the silicon pin before it is embedded into a first glass wafer. In one embodiment, forming the P-N device includes selectively diffusing an impurity into the silicon pin and configuring the P-N device to operate as a temperature sensor.

## Description

### BACKGROUND OF THE INVENTION

Micro-electromechanical systems (MEMS) devices, such as a MEMS gyroscope device, generally require a temperature compensation circuit to account for sensor output drift as a function of temperature, where the sensor includes at least the movable, mechanical feature or features of the MEMS device. Conventional MEMS devices measure the temperature far away from the sensor, which limits the ability to accurately and timely compensate for changes in temperature. For certain devices, in particular the MEMS gyroscope for example, accurate and timely temperature compensation may be directly related to the ability of the device to provide precise readings.

Ambient temperature (*i*.*e*., outside air temperature) may rapidly or slowly change. Because of the ambient temperature change and/or because of a temperature change caused by the control electronics, the various parts of the MEMS device will also change temperature. As a result of different coefficients of thermal expansion of the materials used to make the various parts, the externally or internally induced thermal stresses may cause mechanical strains, particularly in the moving parts of the MEMS device. The thermal stress, and possibly changes in the part's ductility, may also change the resonant frequency of moving parts.

### BRIEF SUMMARY OF THE INVENTION

The present invention generally relates to a MEMS device having a P-N device formed on a silicon substrate and from which at least one silicon pin is etched therefrom and embedded into a glass wafer. The silicon pin is connected to a silicon sub-assembly and a P-N device is formed on the silicon pin before it is embedded into the glass wafer. In one embodiment, the silicon sub-assembly is located (*e*.*g*., sandwiched) between a first glass wafer located adjacent to a second glass wafer. By way of example, only the silicon pins are embedded into the first and second glass wafers, not the silicon sub-assembly. The silicon sub assembly is merely sandwiched between the glass wafers. In one embodiment, one or more silicon pins may operate as a temperature sensor by selectively diffusing an impurity to make a P-N device and then setting up a desired electrical connection and measurement system to make the P-N device operate as a temperature sensor.

In one aspect of the invention, a MEMS device includes a glass wafer and a silicon sub-assembly. The silicon sub-assembly includes at least one movable mechanical device. A conductive element is positioned within the glass wafer and located proximate the silicon sub-assembly. A silicon pin includes a first end coupled to the conductive element and extends substantially perpendicular from the conductive element. Further, the silicon pin includes a second end located proximate an exterior surface of the glass wafer. The MEMS device further includes a P-N device located on the second end of the silicon pin and formed by selective diffusion (*e*.*g*., selectively diffusing an impurity) before the silicon pin is etched from a silicon substrate and before the silicon pin is embedded into the glass wafer. In one embodiment, the P-N device is formed by growing an epitaxial layer onto a portion of the silicon substrate that is to be used as the second end of the silicon pin.

In yet another aspect of the invention, a method for making a MEMS device includes the steps of (1) making a first glass wafer with appropriate cavities and conductive elements; (2) making a silicon sub-assembly; (3) bonding at least a portion of the silicon sub-assembly to the first glass wafer; (4) growing an appropriately doped epitaxial layer into a silicon wafer to make a P-N device; (5) etching the silicon wafer to form silicon pins, at least one silicon pin having the P-N device formed on a first end of the silicon pin; (6) embedding the silicon pins into at least the first glass wafer; (7) polishing off the non-embedded part of the silicon pins; and (8) positioning a conductive element proximate the first glass wafer with the embedded silicon pins extending substantially perpendicular from the conductive element, the first end of the silicon pin having the P-N device located distally from a second end of the silicon pin coupled to the conductive element.

In still yet another aspect of the invention, a method for making a MEMS device includes the steps of (1) making a first glass wafer with appropriate cavities and conductive elements; (2) making a silicon sub-assembly; (3) bonding at least a portion of the silicon sub-assembly to the first glass wafer; (4) selectively diffusing impurities into a silicon wafer to make a P-N device; (5) etching the silicon wafer to form silicon pins, at least one silicon pin having the P-N device formed on a first end of the silicon pin; (6) embedding the silicon pins into at least the first glass wafer; (7) polishing off the non-embedded part of the silicon pins; and (8) positioning a conductive element proximate the first glass wafer with the embedded silicon pins extending substantially perpendicular from the conductive element, the first end of the silicon pin having the P-N device located distally from a second end of the silicon pin coupled to the conductive element.

### BRIEF DESCRIPTION OF THE DRAWINGS

Preferred and alternative embodiments of the present invention are described in detail below with reference to the following drawings:

FIGURE 1 is a schematic, cross-sectional view of a MEMS device includes a glass wafer, a silicon sub-assembly and a silicon pin having a P-N device according to an illustrated embodiment of the invention; and

FIGURE 2 is a flow diagram showing a method of making the MEMS device of FIGURE 1 according to an illustrated embodiment of the invention.

### DETAILED DESCRIPTION OF THE PREFERRED EMBODIMENT

In the following description, certain specific details are set forth in order to provide a thorough understanding of various embodiments of the invention. However, one skilled in the art will understand that the invention may be practiced without these details or with various combinations of these details. In other instances, well-known structures and methods associated with micro-electromechanical systems (MEMS) devices, such as MEMS gyroscopes having P-N devices, silicon substrates, glass wafers and methods of making the same may not be shown or described in detail to avoid unnecessarily obscuring descriptions of the embodiments of the invention.

The following description is generally directed to a MEMS device having a P-N device formed on a silicon pin, which is connected to a silicon sub-assembly located or otherwise sandwiched between two glass wafers, and where the P-N device is formed before the silicon pin is embedded into either of the glass wafers. Forming the P-N device may include selectively diffusing an impurity so that the P-N device operates as a temperature sensor. In one advantageous embodiment, the P-N device formed on the silicon pin may provide a substantial signal-to-noise improvement over other types of temperature sensors. By way of example, the P-N device formed on the silicon pin may provide an exponentially improved signal-to-noise ratio of approximately ten to the power of three (10³) over other types of temperature sensors such as thermocouples or platinum resistive temperature detectors (RTD). In one embodiment, the MEMS device may be a MEMS gyroscope that requires a temperature compensation circuit to compensate for output drift of the MEMS sensor as a function of temperature.

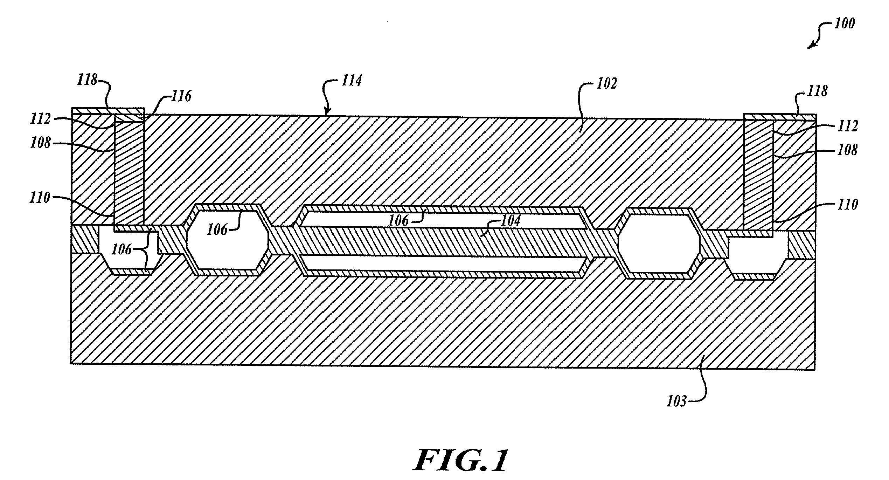

FIGURE 1 shows a MEMS device 100 having a first glass wafer 102 and a second glass wafer 103. Each of the glass wafers 102, 103 may have its own conductive element 106 bonded to the respective glass wafer 102, 103, in which the respective conductive elements 106 may be differently, symmetrically or identically configured. A silicon sub-assembly 104 is located or sandwiched between the glass wafers 102, 103. In one embodiment, the silicon sub-assembly 104 includes at least one movable mechanical device, for example a mechanical device that may be used to measure a linear or rotational acceleration. At least one silicon pin 108 extends from the silicon sub-assembly 104 and includes a first end 110 and a second end 112. In the illustrated embodiment, the first end 110 is coupled to the conductive element 106 and the second end 112 is located proximate an exterior surface 114 of the first glass wafer 102. The silicon pin 108 may extend substantially perpendicular from the conductive element 106. Located at the second end 112 is a P-N device 116 that may be formed by selectively diffusing an impurity into the silicon pin 108 to produce either an N-type or a P-type epitaxial layer. The type of layer produced, whether N-type or P-type, depends on a composition of the silicon pin 108. Importantly, the P-N device 116 is selectively diffused before a glass material of the glass wafer 102 has been molten to embed the silicon pin 108. By way of example, multiple silicon pins 108 may extend from the silicon sub-assembly 104 in a variety of directions and be embedded in one or both of the glass wafers 102, 103, but only a few of the silicon pins 108 would include P-N devices 116. Generally, many of the silicon pins 108 may be configured without a P-N device and be used to connect the internal silicon sub-assembly 104 to a device that resides outside of the glass wafers 102, 103. Of the remaining silicon pins that do include P-N devices, at least one may operate as temperature sensor.

Each glass wafer 102, 103 may be independently formed from a single, one-piece structure. In one embodiment, the glass wafers 102, 103 have a high thermal shock resistance. A glass material from which the glass wafers 102, 103 are formed may be Borofloat® or Pyrex® brand glass material. By way of example, a total thickness of the glass wafers 102, 103 after being placed in an abutted relationship may be in a range of about 15-30 thousandths of an inch, otherwise commonly referred to as mils.

The silicon sub-assembly 104 may be formed from a single crystal silicon structure before being located or sandwiched between the glass wafers 102, 103. The silicon sub-assembly 104 may further include a movable mechanical component such as a component that may be used to detect a linear or rotational acceleration. The movable mechanical component may take a variety of forms, for example a cantilevered beam etched into the silicon sub-assembly 104.

Further included in the MEMS device 100 is the conductive element 106 in which at least a portion of the conductive element 106 is positioned proximate the silicon sub-assembly 104 and may be bonded to at least one of the glass wafers 102, 103. The conductive element 106 may take the form of a metal strip. The conductive element 106 may be configured to route signals the silicon pins 108, which may then transmit the signals through the glass wafers 102, 104. The conductive element 106 may be a continuous strip or may be segmented and electrically coupled to portions of the silicon sub-assembly 104. In the illustrated embodiment, the conductive element 106 provides an electrical connection between the silicon pin 108 and the silicon sub-assembly 104.

In the illustrated embodiment, the silicon pins 108 have the first end 110 coupled to the conductive element 106 and the second end 112 located proximate the exterior surface 114 of the glass wafer 102. Example processes of forming a glass wafer that contains a silicon pin is performed by Plan Optik, AG, a German company. During formation of the silicon pins 108 and as described in greater detail below, the second end 112 may initially extend beyond the exterior surface 114 and then later be machined down to be flush or approximately flush with the exterior surface 114. By way of example, at least one surface of the P-N device, specifically the distal surface (*i*.*e*., distal from the conductive element 106) of the second end 112, remains uncovered by the exterior surface 114 of the glass wafer 102. In addition, forming the P-N devices onto the silicon pins 108 occurs before the silicon pins 108 are embedded or encased in the glass material that will form at least the first glass wafer 102. In one embodiment, the silicon pin 108 may extend substantially perpendicular from the conductive element 106.

Still referring to the second end 112 of the silicon pin 108, a P-N device 116 is created or formed on the second end 112. One purpose of forming the P-N device 116 is to provide a temperature sensor that is built directly on the MEMS device 100. The P-N device 116 may advantageously provide a more accurate temperature measurement of the silicon sub-assembly 104 when compared to other types of temperature measurement devices, such as thermocouples or resistive temperature detectors (RTDs) that could be used with the MEMS device 100.

The P-N device 116 is formed by growing an epitaxial layer onto the second end 112 of the silicon pin 108. In one embodiment, forming the P-N devices onto the silicon pins 108 occurs before the silicon pins 108 are formed meaning the doping or epitaxy is done before forming the silicon pins 108. By way of example, the doping or epitaxy is performed on a silicon substrate and next the silicon pins 108 are etched from the substrate with the P-N devices already located on ends 112 of selected silicon pins 108. And next, the silicon pins 108 are then embedded or encased in the glass material of at least the first glass wafer 102. Epitaxial generally refers to an ordered crystalline grown on a mono-crystalline substrate, for example the silicon substrate. In one embodiment, the epitaxial layer may be grown from a gaseous or liquid precursor because portions of the silicon substrate that will become ends 112 of the silicon pins 108 function as seed crystals, which allows the epitaxial layer to take on a desired lattice structure and orientation. In another embodiment, the epitaxial layer may be deposited onto the silicon substrate in accordance with other deposition or growth processes known in the art.

The P-N device 116 may be created by selectively diffusing an impurity, otherwise referred to as a dopant, at a high temperature in a range of about 800-900 degrees Celsius (°C) proximate the second end 112 of the silicon pin 108. The selective diffusion is preferably completed before the silicon pins 108 are etched or otherwise produced from a base silicon wafer. In one embodiment, the P-N device 116 includes a P-type semiconductor material located on an N-type semiconductor material. In another embodiment, the P-N device 116 includes an N-type semiconductor material located on a P-type semiconductor material.

The P-N device 116 may be forward-biased or reverse-biased, but preferably is reverse-biased to function as a temperature sensor. In the reverse-biased configuration, the current through the P-N device has an exponential temperature dependence. External electronics are used to measure this current and then calculate the temperature.

The forward-bias and the reverse-bias properties of the P-N device 116 permit the device to be employed as a diode. By way of example, a P-N device 116 taking the form of a P-N diode allows electric charges to flow in one direction, but not in the opposite direction. For example, negative charges (electrons) flow through the junction from N to P, but not from P to N, if forward biased; and vice-versa if reverse biased. When the P-N device 116 is forward-biased, electric charge flows freely due to reduced resistance. When the P-N device 116 is reverse-biased, the resistance to electric charge flow becomes greater such that the resulting charge flow may be minimal and by way of example it is this minimal flow that may be used to measure the temperature. Optionally and instead of forming the P-N device 116, but after embedding the aforementioned components in the glass wafer 102, a Schottky barrier, diode or rectifier (not shown) may be formed at the second end 112 of the silicon pin 108.

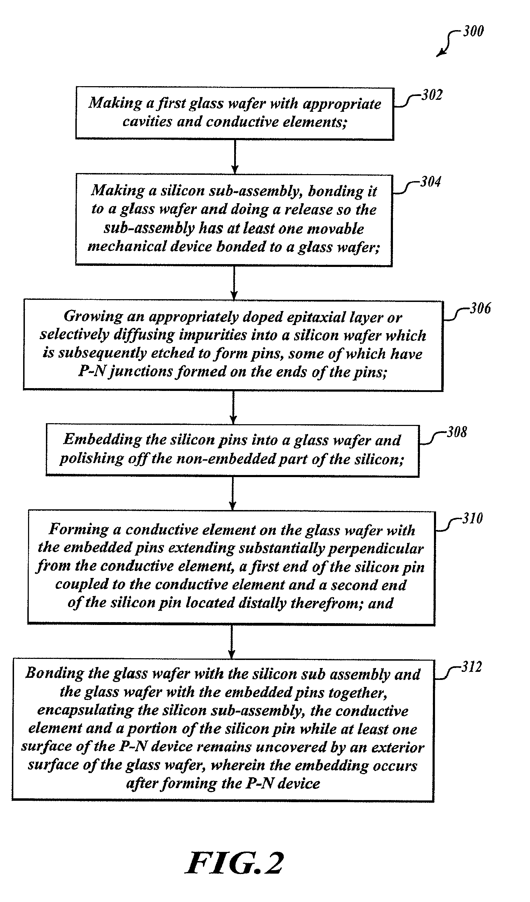

In one aspect of the invention, FIGURE 2 shows a method 300 for making a MEMS device includes at step 302 making a first glass wafer with appropriate cavities and conductive elements. At step 304, making a silicon sub-assembly, bonding it to a glass wafer and doing a release so the sub-assembly has at least one movable mechanical device bonded to a glass wafer. At step 306, growing an appropriately doped epitaxial layer or selectively diffusing impurities into a silicon wafer which is subsequently etched to form pins, some of which have P-N devices formed on ends of the pins. At step 308, embedding the silicon pins into a glass wafer and polishing off the non-embedded part of the silicon. At step 310, forming a conductive element on the glass wafer with the embedded pins extending substantially perpendicular from the conductive element, a first end of the silicon pin coupled to the conductive element and a second end of the silicon pin located distally therefrom. And at step 312, bonding the glass wafer with the silicon sub assembly and the glass wafer with the embedded pins together, encapsulating the silicon sub-assembly, the conductive element and a portion of the silicon pin while at least one surface of the P-N device is remains uncovered by an exterior surface of the glass wafer, wherein the embedding occurs after forming the P-N device.

While the preferred embodiment of the invention has been illustrated and described, as noted above, many changes can be made without departing from the spirit and scope of the invention. Accordingly, the scope of the invention is not limited by the disclosure of the preferred embodiment. Instead, the invention should be determined entirely by reference to the claims that follow.

## Claims

1. A MEMS device comprising:
a MEMS component attached to a glass wafer;
a silicon pin in signal communication with the MEMS component, the silicon pin having one end portion located proximate an exterior surface of the glass wafer; and
a temperature sensor attached to the one end portion of the silicon pin, the temperature sensor configured detect a temperature of the MEMS component, the temperature sensor comprising a P-N device located on the one end portion of the silicon pin and formed by selective diffusion before, wherein the P-N device is created before the forming of the silicon pin and before the silicon pin is embedded into the glass wafer.

2. The MEMS device of Claim 1, wherein the silicon pin is made from a single crystal silicon structure.

3. The MEMS device of Claim 1, wherein the P-N device is reversed biased.

4. A MEMS device comprising:
a glass wafer;
a silicon sub-assembly coupled to the glass wafer, the silicon sub-assembly having at least one movable mechanical device;
a conductive element positioned within the glass wafer and located proximate the silicon sub-assembly;
a silicon pin includes a first end coupled to the conductive element and extends substantially perpendicular from the conductive element, the silicon pin further includes a second end located proximate an exterior surface of the glass wafer; and
a P-N device located on the second end of the silicon pin and formed by selective diffusion, wherein the P-N device is created before the forming of the silicon pin and before the silicon pin is embedded into the glass wafer.

5. The MEMS device of Claim 4, wherein the silicon sub-assembly is made from a single crystal silicon structure.

6. The MEMS device of Claim 4, wherein the glass wafer is made from a high thermal shock resistant glass material.

7. The MEMS device of Claim 4, wherein the glass wafer includes a thickness in a range of about 15-30 thousandths of an inch.

8. The MEMS device of Claim 4, wherein the P-N device is a reversed biased P-N device that generates an output signal in response to a change in temperature of the silicon sub-assembly.

9. A method for making a MEMS device, the method comprising:
making a first glass wafer with appropriate cavities and conductive elements;
making a silicon sub-assembly;
bonding at least a portion of the silicon sub-assembly to the first glass wafer;
growing an appropriately doped epitaxial layer into a silicon wafer to make a P-N device;
etching the silicon wafer to form silicon pins, at least one silicon pin having the P-N device formed on a first end of the silicon pin;
embedding the silicon pins into at least the first glass wafer;
polishing off the non-embedded part of the silicon pins; and
positioning a conductive element proximate the first glass wafer with the embedded silicon pins extending substantially perpendicular from the conductive element, the first end of the silicon pin having the P-N device located distally from a second end of the silicon pin coupled to the conductive element.
